# EUROPEAN PATENT APPLICATION

(11) **EP 2 410 556 A2**
(43) Date of publication of application: **25.01.2012**
(21) Application number: 11174885.1
(22) Date of filing: 21.07.2011
(51) Int. Cl.: H01L 21/02, H01L 21/36

(54) **Sodium sputtering doping method for large scale CIGS based thin film photovoltaic materials**

(30) Priority: 23.07.2010 US 367030 P; 29.06.2011 US 171839
(71) Applicant: Stion Corporation, San Jose, CA 95119 (US)
(72) Inventor: Shao, May, Pflugerville, TX Texas 78660 (US)
(74) Representative: Office Freylinger

(57) **Abstract**

A method of processing sodium doping for thin-film photovoltaic material includes forming a metallic electrode on a substrate. A sputter deposition using a first target device comprising 4-12 wt% Na₂SeO₃ and 88-96 wt% copper-gallium species is used to form a first precursor with a first Cu/Ga composition ratio. A second precursor over the first precursor has copper species and gallium species deposited using a second target device with a second Cu/Ga composition ratio substantially equal to the first Cu/Ga composition ratio. A third precursor comprising indium material overlies the second precursor. The precursor layers are subjected to a thermal reaction with at least selenium species to cause formation of an absorber material comprising sodium species and a copper to indium-gallium atomic ratio of about 0.9.

## Description

### CROSS-REFERENCE TO RELATED APPLICATION

This application claims priority to U.S. Provisional Application No. 61/367,030, filed July 23, 2010, commonly assigned, and hereby incorporated by reference in its entirety herein for all purpose.

### BACKGROUND OF THE INVENTION

This invention relates generally to thin-film photovoltaic materials and manufacturing methods. More particularly, the invention provides a method and structure for doping sodium in a precursor for forming photovoltaic materials. The present method includes in-chamber sodium sputter doping for the manufacture of chalcopyrite photovoltaic materials, but it would be recognized that the invention may have other configurations.

Mankind long has been challenged to find ways of harnessing energy. Energy comes in various forms such as petrochemical, hydroelectric, nuclear, wind, biomass, solar, wood and coal. Solar energy technology generally converts electromagnetic radiation from the sun to other useful forms of energy. These other forms of energy include thermal energy and electrical power. For electrical power applications, solar cells are often used. Although solar energy is environmentally clean and has been successful, many limitations remain to be resolved before it becomes widely used throughout the world. As an example, one type of solar cell uses crystalline materials, which are derived from semiconductor material ingots. These crystalline materials can be used to fabricate optoelectronic devices that include photovoltaic and photodiode devices that convert electromagnetic radiation into electrical power. Crystalline materials, however, are often costly and difficult to make on a large scale. Additionally, devices made from such crystalline materials often have low energy conversion efficiencies. Other types of solar cells use "thin film" technology to form a thin film of photosensitive material to be used to convert electromagnetic radiation into electrical power. Similar limitations exist with the use of thin film technology in making solar cells, that is, efficiencies are often poor. Additionally, film reliability is often poor and cannot be used for extensive periods of time in conventional environmental applications. Often, thin films are difficult to mechanically integrate with each other. Furthermore, integration of electrode materials and overlying absorber materials formed on sodium containing substrate is also problematic, especially for large scale manufacture.

### BRIEF SUMMARY OF THE INVENTION

This invention relates generally to photovoltaic materials and manufacturing methods. More particularly, the invention provides a method and structure for fabricating thin-film photovoltaic materials. The method includes an in-chamber sputter deposition of a sodium-bearing multi-layer precursor material comprising copper, gallium, and indium species for the manufacture of a copper-based absorber material through thermal reactive treatments, but it would be recognized that the invention may have other configurations.

In a specific embodiment, the invention provides a method of processing sodium doping for thin-film photovoltaic material. The method includes providing a transparent substrate which has a surface and an oxide material overlying the surface. A metallic electrode material is formed over the oxide. Additionally, the method includes performing a sputter deposition process using at least a first target device with 4-12 wt% Na₂SeO₃ compound species and 88-96 wt% copper-gallium species to form a first precursor material. The copper-gallium species is characterized by a first Cu-Ga composition ratio. A second precursor material is formed over the first precursor material and includes copper species and gallium species which are deposited using a second target device having a second Cu-Ga composition ratio substantially equal to the first Cu-Ga composition ratio. Then a third precursor material including indium is formed over the second precursor material. A thermal reactive treatment in at least gaseous selenium species then causes formation of an absorber material which includes sodium and copper to indium-gallium atomic ratio about 0.9.

In another embodiment, the invention provides a structure for forming a photovoltaic material. The structure includes a substrate having a surface and a molybdenum material over the surface. Sodium bearing material overlies the molybdenum material. The sodium bearing material is formed by using a first sputtering target device with about 8 wt% of Na₂SeO₃ and 92 wt% of copper-gallium with copper greater than 80%. Copper-gallium material overlies the sodium bearing material. The copper-gallium material is formed using a second sputtering target device comprising Cu-Ga species having a second composition of copper substantially equal to the first composition of copper. Indium overlies the copper-gallium material. The indium material is formed using a third sputtering target device of substantially pure In species. The sodium bearing material, the copper-gallium material, and the indium material form a precursor to be subjected to a thermal reactive treatment for forming a photovoltaic material.

In another embodiment, the invention provides a method of processing sodium doping for thin-film photovoltaic material. The method includes providing a substrate with a surface and a dielectric material overlying the surface. A metallic electrode is formed over the dielectric material. Then a sputter deposition process using at least a first target device having a sodium species, a copper species, and a gallium species are used to form a first precursor material. A second precursor material is formed over the first precursor material, the second precursor material including a copper species and a gallium species deposited using a second target device. A third precursor material comprising indium is formed over the second precursor material. The method includes subjecting the precursor materials to a thermal treatment in an environment which includes selenium to cause formation of an absorber material.

The sodium doping process serves an important step for forming copper based chalcopyrite structured high efficiency photovoltaic material. The invention provides an efficient way using an in-chamber sputtering process to perform the sodium doping. The process allows a well controlled sodium concentration during a formation of a precursor. The method simplifies the doping process to perform sputtering processes that cause the formation of a copper, gallium, and indium based composite material as the precursor. The sodium doping can be performed in a specific compartment of an in-line chamber using a specifically selected sodium bearing composite target device, while copper-gallium or indium materials can be formed in separate compartments of the same chamber for depositing a multi-layer composite material with predetermined composition ratio. The multi-layer composite material then is served as a precursor subjected to at least one thermal treatment in a gaseous ambient comprising at least selenium species to cause the formation of copper-based chalcopyrite compound material, which becomes a high-efficiency photovoltaic absorber material.

### BRIEF DESCRIPTION OF THE DRAWINGS

Figure 1 is a flowchart illustrating a method of fabricating a thin-film photovoltaic material;

Figures 2-9 are schematic diagrams illustrating a method and a structure for fabricating a thin-film photovoltaic absorber material;

Figure 10 is a cross-section side view of an in-line chamber for depositing a sodium bearing precursor for forming photovoltaic absorber material; and

Figure 11 is a top view of a furnace system for thermally treating precursors doped with sodium to cause formation of photovoltaic absorber materials.

### DETAILED DESCRIPTION OF THE INVENTION

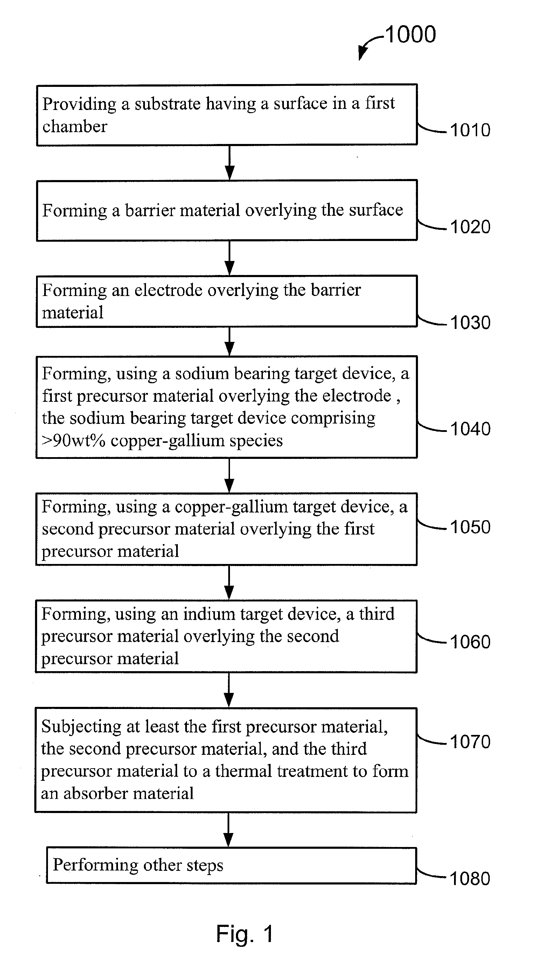

Figure 1 is a flowchart illustrating a method of fabricating a thin-film photovoltaic material according to an embodiment of the present invention. The method 1000 includes the following processes:
1. Process 1010 for providing a transparent substrate having a surface;
2. Process 1020 for forming a barrier material on the surface;
3. Process 1030 for forming an electrode;
4. Process 1040 for forming, using a sodium bearing target device, a first precursor material overlying the electrode, the sodium bearing target device comprising >90% copper-gallium species;
5. Process 1050 for forming, using a copper-gallium target device, a second precursor material overlying the first precursor material;
6. Process 1060 for forming, using an indium target device, a third precursor material overlying the second precursor material;
7. Process 1070 for subjecting at least the first precursor material, the second precursor material, and the third precursor material to a thermal treatment to form a copper-based absorber material;
8. Process 1080 for performing other steps.

The above sequence of processes provides a method of doping sodium for forming a copper-based chalcopyrite structured photovoltaic material. The method includes an in-chamber sodium sputter doping process to form a sodium bearing material and a sputter deposition process to form copper-gallium material and indium material with proper stoichiometry control before performing a thermal treatment process. In another specific embodiment, the method also includes performing sputtering processes in different compartments within the same in-line chamber. After the precursor formation the substrate bearing the first, the second, and the third precursor can be transferred out of the in-line chamber and into a furnace system for thermal treatment. In another example, additional films including a window material and transparent electrode materials can be added overlying the just formed copper-based absorber material for the manufacture of thin-film photovoltaic devices.

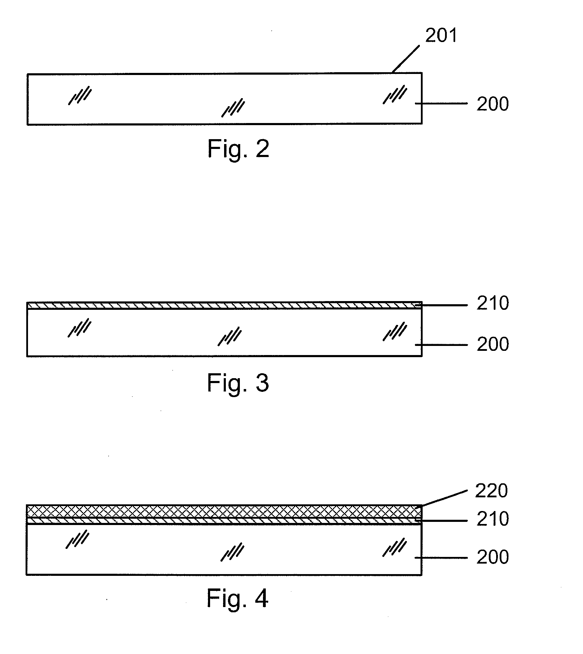

At Process 1010, a soda lime glass substrate is provided. This process is illustrated by Figure 2. Figure 2 is a diagram illustrating a transparent substrate provided for fabricating a thin-film photovoltaic device according to an embodiment of the present invention. As shown, transparent substrate 200 is provided. The transparent substrate 200 has a surface 201. In an implementation, the substrate 200 can be a planar shape as shown although other shapes depending on the photovoltaic cell applications can be possible, including tubular, circular, hemi-spherical, or even flexible (like a foil) shape. The transparent substrate 100 uses a soda lime glass material which has been widely used as window glass, as well as the substrate for forming thin-film photovoltaic cells. The soda lime glass naturally contains alkaline ions (e.g., Na⁺) which provide a positive influence on the grain growth of thin-film photovoltaic materials thereon. For example, semiconductor films of CuIn(Ga)Se₂ or CuInSe₂ materials can be formed on soda lime glass substrates with coarse grain sizes of a few microns or larger. The sodium Na ions also act as dopants in the absorber for the photovoltaic cell. However, it has been known that a well controlled sodium doping concentration plays important role to enhance the performance of the thin-film photovoltaic absorber. Simply using natural origin of sodium in factory-supplied soda lime glass substrate to diffuse to its neighboring substrate is not reliable, especially for irregular shaped substrates. Embodiments of the present invention using sputter deposition based on well controlled sodium bearing target device provides a method of sodium doping.

A Process 1020, an oxide barrier is formed overlying a surface of the substrate provided in Process 1010. This process can be visually illustrated by Figure 3. In a specific embodiment, oxide barrier 210 is formed on the surface 201 of the transparent substrate 200. As mentioned earlier, the transparent substrate often uses soda lime glass which contains certain Na ions therein. These sodium species can diffuse into materials formed on the surface, disturbing the material ingredient and causing structure variation if no control is applied. The oxide barrier 210 serves mainly a diffusion barrier for these un-controlled Na ions and substantially prevents Na from diffusing into the electrode and precursor materials formed later.

Process 1030 includes forming a metallic electrode overlying the oxide barrier. This is illustrated in Figure 4. As shown, the metallic electrode 220 formed overlying the oxide barrier 210. In a specific embodiment, the metallic electrode 220 comprises one or more layers of molybdenum material. The one or more layers of molybdenum material can be formed using one or more deposition processes. For example, the molybdenum material can be deposited using sputter technique. As shown in later paragraphs, the substrate 200 (including the coated oxide barrier) can be loaded into a vacuum chamber. The vacuum chamber, in one implementation, is set up as an in-line configuration where several compartments are built separated by dividers. The substrate can be transferred via a transport device from one compartment to another via slits in the dividers. The chamber can use any one compartment to perform one or more deposition processes including sputtering formation of the metallic electrode 220. Alternatively, the chamber can also be just one of a plurality of chambers or subsystems coupled each other in a large batch system.

The metallic electrode 220 functionally serves a lower or back electrode for a thin-film photovoltaic device to be formed on the substrate 200. In an example, the metallic electrode 220 includes a bi-layer structured molybdenum material sequentially formed at different deposition conditions. Particularly, a first molybdenum layer is formed overlying the oxide barrier 210 using a sputtering process at relative lower pressure of about 2 mTorr. The first molybdenum layer is substantially under a tensile stress. Subsequently, a second molybdenum layer is formed overlying the first molybdenum layer using a sputtering process at relative higher pressure of about 20 mTorr. The second molybdenum layer is substantially under a compressive stress and has a thickness of about 2000 Angstroms or about ten times thicker than the first molybdenum layer. Such bi-layer molybdenum structure with a desired strain field allows a laser patterning process to perform pattern scribing into the molybdenum layer without inducing film cracking. As a result, the plurality of patterns formed in the metallic electrode layer 220 can be utilized to form corresponding interconnect structures required for thin-film photovoltaic device.

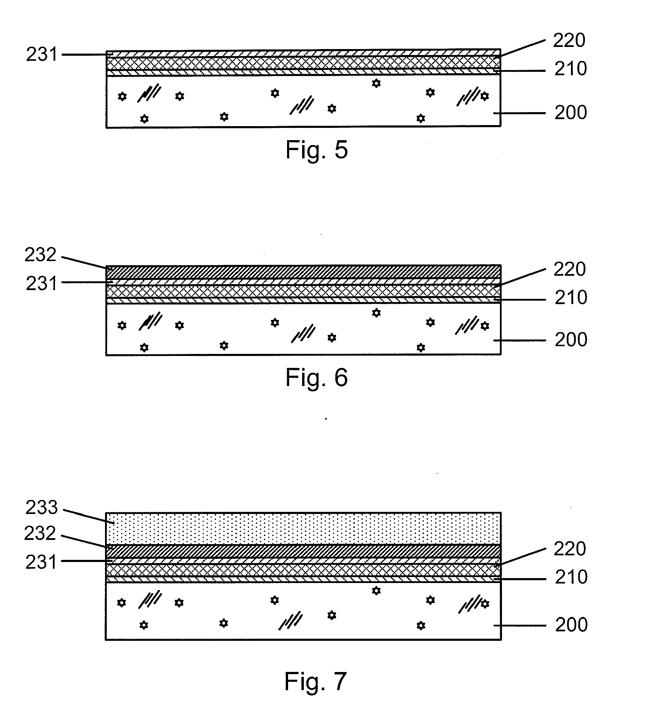

Referring to Figure 1, the method 1000 according to the present invention further includes Process 1040, using a sodium bearing target device for sputter depositing a first precursor overlying the metallic electrode. As shown in Figure 5, a first precursor 231 is formed over the metallic electrode 220. In an embodiment, the deposition is a DC magnetron sputtering process carried in one compartment of an in-line vacuum chamber. The sodium bearing target device disposed in the compartment includes a predetermined sodium composition and predominant amount (>90 wt%) of copper-gallium species. The use of predominant copper-gallium species is based on one or more considerations for forming copper-based precursors following the formation of sodium bearing material for the manufacture of copper-based photovoltaic materials. In an embodiment, the sodium species in the target device is incorporated in ionic form in a compound Na₂SeO₃ species. For example, the sodium bearing target device includes Na₂SeO₃ species ranged from 4 wt% to 12 wt% and copper-gallium species from 88 wt% to 96 wt%. In a preferred embodiment, the sodium bearing target device is made of 8 wt% of Na₂SeO₃ species and 92 wt% of copper-gallium species. Furthermore, within the copper-gallium species copper is dominant with >80 at% in composition. In an example, the Cu:Ga composition ratio is 80:20 (in terms of atomic concentration). In another example, the Cu:Ga ratio is 85:15. Other ratio values in between are also applicable. In this kind of target device, Na has 2-3 wt% concentration overall.

In another embodiment, sodium species is contained in compound Na₂Se. For example, the sodium bearing target device can contain Na₂Se species ranged from 3 wt% to 9 wt% and copper-gallium species ranged from 91 wt% to 97 wt%. Similarly, the target device contains about 2-3 wt% of Na species. In an implementation, a sputtering process can be carried out in one of compartments in the chamber. The compartment can be filled with work gases including Argon gas and/or Nitrogen gas. In a specific embodiment, the sputtering process is initiated via DC magnetron with a power of 1.5 kW or higher. For example, a 1.75 kW power is applied for depositing the first precursor from the sodium bearing target device with Argon gas flow rate of about 200 sccm is used for controlling deposition rate throughout the deposition process. Correspondingly, a sodium area density associated with the deposition rate is determined to be in a range from 0.03 to 0.09 micromoles/cm², a preferred sodium doping concentration for the manufacture of a high efficiency thin-film photovoltaic absorber material. The compartment conducting the sputter deposition can be pre-pumped down to a pressure in a range of a few mTorr before starting work gas flow. In an implementation, the first precursor formed by the sputter deposition has a film thickness of about 60 nm. The first precursor includes at least sodium species, selenium species, copper species, and gallium species and in particular, the first precursor includes about 90% or more Cu-Ga species with copper-gallium composition ratio of about 85:15. The existence of dominant Cu-Ga species in the first precursor serves as a structure base for subsequent addition of copper-gallium materials without inducing much stress and interface crack. Additional copper species needs to be provided for achieving a desired copper and/or gallium composition in photovoltaic material without adding further sodium species. If no control on the dosage of sodium species, as the case using the sodium content in soda lime glass without diffusion control, actually does no good but harm to enhance the photovoltaic efficiency.

Referring to Figure 1 again, the method 1000 further includes a process 1050 for forming a second precursor overlying the first precursor. Process 1050 is illustrated in Figure 6. As shown, the second precursor 232 is formed overlying the first precursor 231. In an embodiment, Process 1050 uses a sputter deposition technique from a copper-gallium target device to deposit the second precursor 232 containing substantially pure copper and gallium species. In an implementation, the copper-gallium target device used in the process contains 99.9% pure copper-gallium alloy, wherein the copper-gallium composition ratio is selected to be substantially equal to the copper-gallium composition ratio in the sodium bearing target device. For example, the sodium bearing target device includes about 92 wt% of copper-gallium species having a composition ratio ranging from 80:20 to 85:15. The corresponding copper-gallium target device can have a copper-gallium composition ratio substantially equal to 85:15 (i.e., 85% Cu, 15% Ga). The composition matching should help to grow the second precursor film smoothly on the first precursor film substantially without inducing interface lattice stress and forming potential cracks.

In an alternative embodiment, process 1050 is performed in a different compartment from one for sputter depositing the sodium bearing material. The substrate 200 can be transferred through one or more slits built in a lower portion of compartment dividers. Argon gas can be used again as the work gas for the sputtering process. The work gas can be distributed into the specific compartment through one or more windows built on the top portion of compartment dividers. DC magnetron sputtering technique is performed with target power set at about 4±1 kW and Argon gas flow rate set at about 170 sccm to control deposition rate of Cu-Ga species. In an example, the second precursor is deposited to a thickness that is about twice of the thickness of the first precursor for achieving an optimum composition for corresponding species. For example, the first precursor comprising copper-gallium species with sodium doped has a thickness of about 60 nm, the subsequent second precursor comprising pure copper-gallium species has a thickness of about 120 nm. The corresponding mole density for CuGa associated with the second precursor ranges from 1.5 to 2 micromoles/cm². Though the deposition is controlled by adjusting the work gas flow rate with a fixed DC power level, the deposition process is at least pre-conditioned in a vacuum environment, which is about 5 mTorr and less or about 1 mTorr to about 42 mTorr. Additionally, the compartment can be further supported by adding a cryogenic pump or a polycold system for attracting water vapor to reduce damages to the sodium bearing material formed in this process. Furthermore, the sputter deposition can be performed under suitable substrate temperatures such as about 20 degrees Celsius to about 110 degrees Celsius according to a specific embodiment. The Process 1050 leads partially to a formation of a composite precursor film to be caused a formation of a copper-based chalcopyrite structure photovoltaic absorber material. Further development of the composite precursor film can be found in more detail below.

In a next process (1060), the method 1000 includes another sputtering process for forming, using an indium target device, a third precursor overlying the second precursor. This process can be visually illustrated and described in following specification. Figure 7 is a simplified diagram illustrating a third precursor being sputter deposited over a second precursor according to an embodiment of the present invention. As shown, the third precursor 233 is an indium material formed overlying the second precursor 232 comprising copper and gallium species. In an example, an indium target device containing indium species with substantially high purity up to 99.99% is used in a DC Magnetron sputtering process to grow the indium material 233. In an embodiment, the indium target device is disposed in a separate compartment next to the compartment used for depositing Cu-Ga layer 232 in the same in-line chamber. The sputtering work gas can be Argon gas, which is released into the corresponding compartment through the windows disposed on top portion of dividers of the compartments. The compartment for forming Indium material via sputter deposition may be one located near an end portion of the in-line chamber or one located next to an entry port of another in-line chamber (either for different thin-film deposition, patterning, or thermal processing). A valve device can be added at the divider to ensure the in-line chamber in proper vacuum condition isolated from ambient or neighboring compartment of next in-line chamber.

The formation of the third precursor leads at least partially to the formation of the composite precursor material to be caused a formation of a copper-based chalcopyrite structured photovoltaic absorber material. To form the composite precursor material having its stoichiometry (or composition ratio among the major ingredients) in a certain range, the indium deposition rate is controlled by adjusting Argon gas flow rate and power level applied to the indium target device. The stoichiometry of the composite precursor material can be at least represented by a composition ratio between copper species and sum of indium species plus gallium species (both of them belongs to VI group), namely a CIG composition ratio. In an example, the Ar flow rate is set to about 100 sccm and the DC power used for sputtering is about 9.2 kW. The indium deposition rate determines a mole density of about 1.84 micromoles/cm² for the indium material 233 formed accordingly. In another example, the first precursor containing sodium bearing Cu-Ga species and the second precursor containing pure Cu-Ga species have been formed with a combined thickness of about 180 nm, and correspondingly the indium material deposited at Process 1060 is formed with a thickness of about 290 nm. Therefore, using basically three separate sputter deposition processes, a composite precursor material subsequently including the first precursor, the second precursor and the third precursor is formed. The first precursor is a sodium-bearing copper-gallium material (with certain amount of selenium and other species). The second precursor is a substantially pure copper-gallium alloy with an atomic composition ratio substantially equal to a copper-gallium composition ratio in the first precursor. The third precursor is substantially pure indium material. The resulted CIG compositing ratio among the composite precursor material is in a range of 0.85 to 0.95. According to certain embodiments, the CIG composition ratio near 0.9 is a preferred composition ratio for causing a formation of the copper-based chalcopyrite structure photovoltaic material producing high efficiency solar conversion.

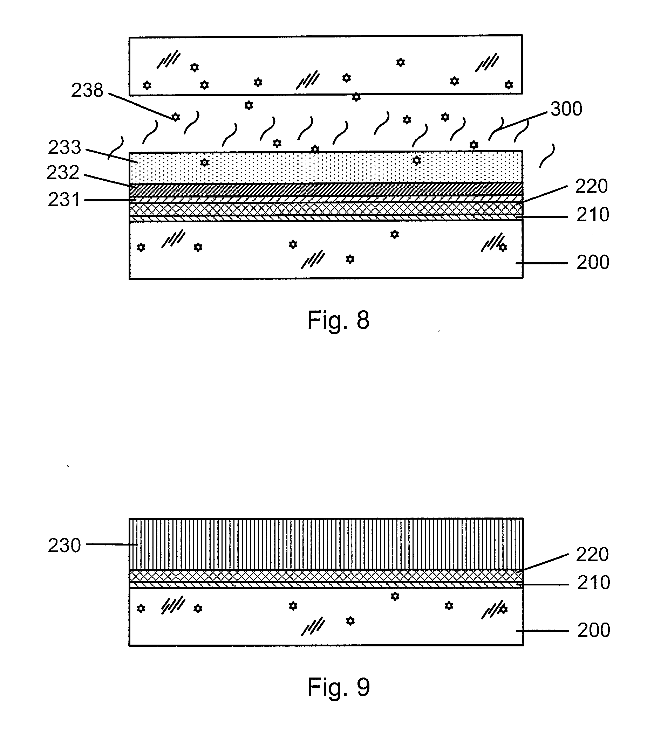

Referring again to Figure 1, the method 1000 further includes a thermal treatment process (Process 1070) for causing a formation of a sodium bearing copper-based absorber material. This process is illustrated by Figure 8 and Figure 9. Figure 8 shows a schematic diagram illustrating a process for subjecting at least the composite precursor material to a thermal treatment according to an embodiment of the present invention. As shown, the substrate 200 with at least the composite precursor including the first precursor 231, the second precursor 232, and the third precursor 233, is disposed to an isolated environment and subjected to a thermal treatment 300. In a specific embodiment, the isolated environment can be a furnace enclosed a volume of space filled with one or more work gases. Particularly, the work gas is reactive and intended for inducing a chemical reaction with the composite material and causing a formation of a photovoltaic absorber material. In a specific embodiment, the work gas is Hydrogen Selenide gas. In another specific embodiment, the work gas is elemental selenium in vapor phase. In yet another embodiment, the work gas may include certain amount of nitrogen gas mixed with gaseous selenium species. Additionally, the thermal treatment 300 is conducted using a heating device associated with the furnace. The heating device is able to ramp up substrate temperature from room temperature to 500 degrees Celsius and greater and able to withhold at a certain fixed temperature during one or more dwell stages. It further includes certain cooling device for ramping down the temperature as desired. The gaseous selenium species react with the copper, gallium, and indium species within the composite precursor material heated to the elevated temperature and at the same time the sodium species doped in the first precursor can diffuse throughout the composite precursor materials. As shown in Figure 9, the thermally induced reaction and atomic inter-diffusion cause a transformation of the composite precursor material to a copper-indium-gallium-selenium(-sulfur) CIGS(CIGSS) absorber material 230 (with multiple CIGS/CIGSS grains) which bears photovoltaic characteristics. The CIGS absorber material 230 just formed can be used to manufacture a thin-film photovoltaic cell. The sodium species with well controlled dosage during the formation of the photovoltaic absorber material plays important role in enhancing photo energy conversion efficiency of the manufactured thin-film photovoltaic cell.

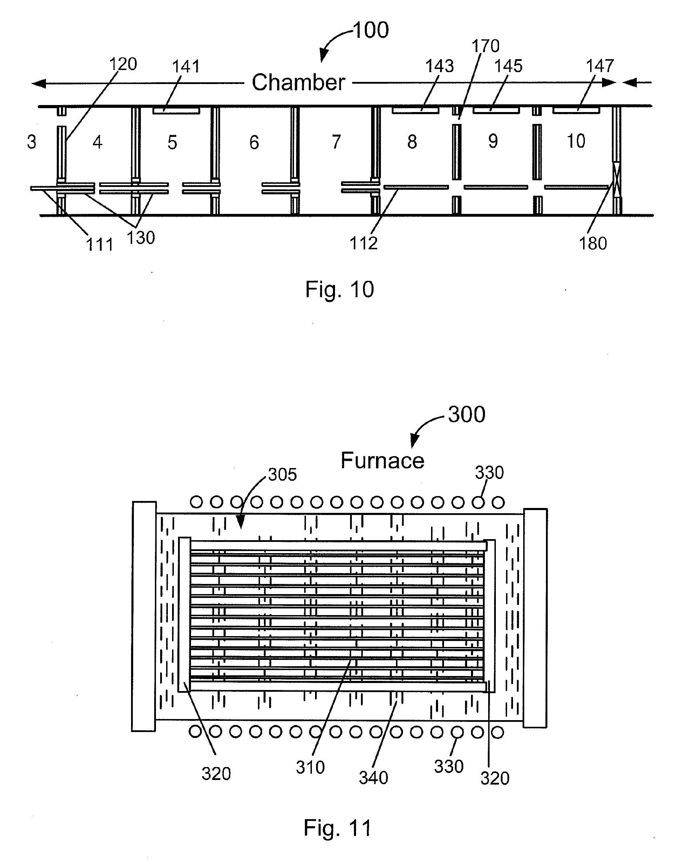

Figure 10 is a schematic cross-section side view of an in-line chamber for depositing a sodium bearing composite precursor material for forming photovoltaic absorber materials according to an embodiment of the present invention. As shown in a specific embodiment, the substrate 111 can be loaded into a chamber 100. Particularly, the substrate 111 is a planar substrate and is firstly disposed in a compartment, for example, compartment 4, where an oxide barrier can be formed overlying a surface of the substrate. Following that, the substrate 111 can be moved to a next compartment (#5) through a slit 130 built in a divider 120. In the compartment 5 a metallic material can be deposited overlying the oxide barrier using a target device 141 disposed therein. The metallic material is used to form an electrode of to-be-formed photovoltaic cells. In particular, the substrate having the metallic material can be patterned and configured to form electric contacts and add cell-cell insulation and external links. These and other processes can be formed in subsequent compartments within the in-line chamber 100.

In some embodiments, substrate 112 including a pre-formed metallic electrode layer is loaded in a compartment, for example, compartment #8, ready for the formation of one or more precursor materials. First, a first precursor material is formed with a sodium-bearing composite material overlying the metallic electrode using a sodium-bearing target device 143 via a DC Magnetron sputtering process. In an embodiment, the sodium bearing target device 143 comprises about 8 wt% of Na₂SeO₃ and 92 wt% of Cu-Ga. The Cu:Ga composition ratio within the sodium bearing target device 143 is ranged from 80:20 to 85:15. The compartment #8 can be filled with Argon gas (and mixed with certain amount of nitrogen) as sputter work gas. The flow rate of Argon gas ranging from 190-250 sccm is used for controlling deposition rate. The substrate can be held at near room temperature and the target power is set to be between 1.2 to 1.8 kW. Next, a formation of a second precursor material can be started as the substrate 112 is transferred to the next compartment (#9), where a Cu-Ga target device 145 is disposed for sputtering a copper-gallium material overlying the first precursor material. The Cu-Ga target device 145 can be a pure (99.9%) Cu-Ga alloy material and an applied power is set to be 3.5 to 4.5 kW. The Argon gas is also used as work gas which can be led into compartment 9 via a window 170 built in the divider 120 separating the compartment 8 and 9. Flow rate of Argon gas into the compartment 9 can be reduced to about 170 sccm to control the copper-gallium deposition rate. Furthermore, a third precursor material can be formed as the substrate 112 is transferred into next compartment #10 where an indium target device 147 is disposed for performing sputter deposition of an indium layer. The indium target contains substantially pure (99.99%) indium material and is applied about 9 kW or higher for conducting sputtering. Again Argon gas flow is adjusted to about 100 sccm for controlling depositing rate of the indium material. As the substrate is about to be transferred out of the in-line chamber 100, a composite precursor material including a sodium bearing composite material, a copper-gallium material, and an indium material is formed. The target power level, work gas flow, target composition, and other process conditions can be adjusted for forming the sodium bearing composite precursor material, although the as mentioned target composition, target power, flow rate are preferred according to embodiments of the present invention. In an embodiment, the substrate 112 can be transferred out from the in-line chamber 100 and then loaded to another chamber or furnace for subjecting at least the composite precursor material to a thermal treatment (e.g., Process 1070). In an implementation, the substrate transfer can be performed without breaking vacuum between the in-line chamber 100 and the next chamber for thermal treatment, simply through a controlled valve 180.

In an alternative embodiment, the next chamber next to the chamber 110 can be a furnace. The next chamber can also be a furnace system equipped with a heating device and a cooling device and enclosed with a spatial region with a gaseous chemical environment. Figure 11 is a schematic cross-section top view of a furnace system for thermally treating the composite precursor materials doped with sodium to cause formation of a photovoltaic absorber material according to an embodiment of the present invention. As shown, furnace 300 can be tubular shaped container having a heating/cooling device 330 surrounded a volume of space 305 where a plurality of substrates 310 bearing the composite precursor materials are loaded via a holding device 320. The volume of space is then filled with a gaseous species 340 containing at least fluidic selenium species in one time period or fluidic sulfur species in another time period for conducting a selenization and/or a sulfurization of the precursor materials.

In a specific embodiment, the thermal reactive treatment process in the furnace 300 is carried at a variable temperature environment capable ramping up from room temperature to about 500 degree Celsius or even greater. The heating device 330 can be configured to ramp up the temperature with a desired rate and control the temperature to a suitable range with an accuracy of about a range of a few degrees. In a specific embodiment, the thermal reactive treatment process is carried out in an environment comprising hydrogen selenide gas for the selenization process of the composite precursor materials. The thermal reactive treatment is substantially a reactive annealing and inter-diffusion process during which copper, gallium, and indium species in the composite precursor film react with the gaseous selenium species and at the same time sodium species in the first precursor material diffuses around. In another specific embodiment, the thermal reactive treatment process is further carried out in an environment comprising fluidic sulfur species for an additional sulfurization process of the composite precursor material (may have gone through the selenization process). In certain embodiments, non-reactive nitrogen gas can be mixed with the reactive selenium gas in the volume of space 305 for enhancing temperature uniformity of the substrates and affecting the reaction rates. In another embodiment, suitable temperature profile is followed to perform the thermal treatment. The temperature profile includes heating the substrates from room temperature to one or more dwell stages with elevated temperatures and cooling back quickly. In an example, the temperature is ramped up to a first dwell stage at about 420±20 degrees Celsius with a work gas containing Selenium/Nitrogen with a certain mix composition, then the temperature is held there for an annealing time period lasting about 1/2 hour to one hour. Then the work gas is pumped out to remove selenium species to substantially stop the reactive process. In certain embodiment, another work gas containing fluidic sulfur species is flowed in, for example, the H₂S gas is added, before the temperature is further ramped up to about 500 degree Celsius or even higher for additional annealing time period. During this period the sulfurization process occurs so that certain amount of selenium species inside the reacted precursor film may be extracted out or replaced by the fluidic sulfur species. As the result of the specific selenization and sulfurization process, a composite film with chalcopyrite structured copper indium gallium diselenide compound CuIn(Ga)Se₂ (CIGS) and copper indium gallium selenium sulfur compound (CIGSS) [also may include compound CuInSe₂ or CuInGaS₂] is formed.

According to an embodiment of the present invention, during the formation of CIGS/CIGSS compound material the sodium bearing layer added in the first precursor material plays an important role in helping the growth of polycrystalline chalcopyrite structured grains. In particular, the sodium ions under a controlled doping concentration help the chalcopyrite grains to grow in relative large size up to a few microns. Without the assistance of sodium ions or with un-controlled excessive supply of sodium content, the chalcopyrite grains would become substantially finer, leading to a great reduction in photovoltaic current and degradation of the efficiency of the solar device. According to embodiments of the present invention, the sodium content can be well controlled using the in-chamber sodium sputter deposition process with a sodium bearing target containing a specific sodium species distributed within a host Na₂SeO₃ material mixed with copper and gallium materials. Additionally, a preferred sputter deposition condition is selected for achieving a desire mole density of sodium doping in the composite precursor material. Of course, there are many alternatives, variations, and modifications for performing sodium doping for forming the photovoltaic absorber material.

In an alternative embodiment, the thermal treatment process can be just a sulfurization process where the furnace system is held in an environment with a fluidicphase sulfur bearing species. For example, the sulfur bearing species can be provided in a solution, which has dissolved Na₂S, CS₂, (NH₄)₂S, thiosulfate, and others. In another example, the fluidic sulfur bearing species can be hydrogen sulfide gas. As the result of these specific thermal treatment processes involving sulfide, a composite material containing copper indium gallium disulfide compound CuIn(Ga)S₂ or CuInS₂ also can be found in the absorber material.

Although the above has been illustrated according to specific embodiments, there can be other modifications, alternatives, and variations. It is understood that the examples and embodiments described herein are for illustrative purposes only and that various modifications or changes in light thereof will be suggested to persons skilled in the art and are to be included within the spirit and purview of this application and scope of the appended claims.

## Claims

1. A method of processing sodium doping for thin-film photovoltaic material, the method comprising:
providing at least one substrate, preferably a soda lime glass substrate, having a surface and an oxide material, preferably comprising silicon oxide or titanium oxide as a diffusion barrier, or a dielectric material overlying the surface;
forming a metallic electrode material over the oxide material or the dielectric material, preferably by sputter depositing a bi-layer molybdenum material;
performing a sputter deposition process using at least a first target device comprising a sodium species and a copper species and a gallium species to form a first precursor material, the copper-gallium species being **characterized by** a first Cu-Ga composition ratio;
forming a second precursor material overlying the first precursor material, the second precursor material comprising copper species and gallium species deposited using a second target device having a second Cu-Ga composition ratio substantially equal to the first Cu-Ga composition ratio;
forming a third precursor material, the third precursor material comprising an indium material overlying the second precursor material; and
subjecting at least the first precursor material, the second precursor material, and the third precursor material to at least one thermal reactive treatment in an environment comprising at least selenium species, preferably a gaseous selenium species, to cause formation of an absorber material, the absorber material preferably comprising sodium species and copper to indium-gallium atomic ratio about 0.9.

2. The method of claim 1 wherein the first target device comprises 4-12 wt% Na₂SeO₃ compound species and 88-96 wt% copper species and gallium species to form said first precursor material, the copper species and gallium species being **characterized by** a first Cu-Ga composition ratio, and preferably about 8 wt% Na₂SeO₃ compound species and 92 wt% copper species and gallium species, wherein the first composition ratio of Cu-Ga is preferably ranged from 80:20 to 85:15.

3. The method of claim 1 or 2 wherein performing a sputter deposition process using the first target device comprises disposing the first target device in a first compartment of an in-line chamber and optionally further comprises using DC Magnetron power of about 1.75 kW and controlling Argon gas flow of about 200 sccm into the first compartment.

4. The method of claim 3 wherein forming a second precursor material comprises performing a sputter deposition process using the second target device disposed in a second compartment of the in-line chamber that is separated from the first compartment.

5. The method of claim 4 wherein the second target device comprises 99.9% Cu-Ga species subjected to a DC Magnetron power of about 4kW with about 170 sccm Argon gas flown into the second compartment.

6. The method of any one of claims 3 to 5 wherein forming a third precursor material comprises using an indium target device comprising 99.99% In disposed in a third compartment of the in-line chamber and optionally further comprises using DC Magnetron power of about 9.2 kW and controlling Argon gas flow of about 100 sccm into the third compartment.

7. The method of any one of claims 1 to 6 wherein forming a third precursor material further comprises forming the indium material up to a thickness that is proportional to a combined thickness of the first precursor material and the second precursor material so that a copper-to-combined indium- gallium atomic ratio in the absorber material ranges from 0.85 to 0.95.

8. The method of any one of claims 1 to 7, wherein the at least one thermal reactive treatment is performed in a furnace with temperature ramping up from room temperature to above about 500 degrees Celsius or greater.

9. The method of any one of claims 1 to 8, wherein the at least one thermal reactive treatment further comprises using a fluidic sulfur species to at least partially replace the selenium species.

10. The method of any one of claims 1 to 9, wherein the absorber material comprises CuInSe₂, CuIn(Ga)Se₂, CuInGaSeₓS₁₋ₓ, CuIn(Ga)S₂.

11. The method of any one of claims 1 to 10, wherein the absorber material comprises a sodium atomic concentration of about 5x10¹⁶ atoms/cm².

12. A structure for forming a photovoltaic material, the structure comprising:
a substrate, preferably a soda lime glass, having a surface and a molybdenum material overlying the surface, said molybdenum material being preferably formed on an oxide barrier material overlying the surface;
a sodium bearing material overlying the molybdenum material, the sodium bearing material being formed by using a first sputtering target device comprising about 8 wt% of Na₂SeO₃ species and 92 wt% of copper-gallium species having a first composition of copper greater than 80%;
a copper-gallium material overlying the sodium bearing material, the copper-gallium material being formed using a second sputtering target device comprising Cu-Ga species having a second composition of copper substantially equal to the first composition of copper; and
an indium material overlying the copper-gallium material, the indium material being formed using a third sputtering target device comprising substantially pure In species.

13. The structure of claim 12 wherein the sodium bearing material is deposited using a DC sputtering power of about 1.75 kW to obtain a sodium molar density ranged from 0.03 to 0.09 micromole/cm².

14. The structure of claim 12 or 13 wherein the second sputtering target device comprises 99.9% Cu-Ga species with a copper composition of about 85%.

15. The structure of any one of claims 12 to 14 wherein the indium material is deposited up to a predetermined thickness that is proportional to a combined thickness of the sodium bearing material and the copper-gallium material.

16. The structure of any one of claims 12 to 15 wherein the sodium bearing material, the copper-gallium material, and the indium material forms a precursor to be subjected to at least a thermal reaction to cause formation of an absorber material comprising copper to indium-gallium atomic ratio ranging from 0.85 to 0.95, said thermal reaction preferably comprising at least a process of ramping temperature from room temperature to 500 degrees Celsius or greater within a gaseous environment containing selenium and sulfur species.
